Europäisches Patentamt

European Patent Office

Office européen des brevets

(19)

(11) Publication number: **0 206 482**

**A1**

(12) **EUROPEAN PATENT APPLICATION**

(21) Application number: **86303442.7**

(22) Date of filing: **07.05.86**

(51) Int. Cl.⁴: **H03K 17/687**

(30) Priority: **20.05.85 US 736182**

(43) Date of publication of application:
**30.12.86 Bulletin 86/52**

(84) Designated Contracting States:
**DE FR GB IT**

(71) Applicant: **TRW INC.**
**23555 Euclid Avenue**
**Cleveland Ohio 44117(US)**

(72) Inventor: **Kimble, Stewart George**
**1021 Stonebryn Drive**
**Harbor City California 90710(US)**

(74) Representative: **Allden, Thomas Stanley et al**
**A.A. THORNTON & CO. Northumberland**
**House 303-306 High Holborn**
**London WC1V 7LE(GB)**

(54) **Solid state switching circuit.**

(57) A solid state switching device utilizing a pair of series connected enhancement-type MOSFETS - (11,12). The pair of MOSFETS are connected in series switching relationship with the circuit to be controlled (22), the gates and sources of the two MOSFETS being each connected in common. The drain of one MOSFET is fed to the common connection of the control circuit (14) (common ground) while the drain of the other is fed to the controlled circuit - (22) to be switched to complete the return for this circuit when the MOSFETS are driven to their "ON" state.

EP 0 206 482 A1

Xerox Copy Centre

## SOLID STATE SWITCHING CIRCUIT

This invention relates to solid state switching circuits and more particularly, to such a circuit employing MOSFETS connected in a series configuration.

Switching circuits employed for switching string arrays, generally make use of diode switches connected in a blocking shunt configuration. Shunt control can subject an array to damage due to hot spots resulting from partial shadowing. The switching circuit of the present invention also provides several other distinct advantages over such switching circuits of the prior art. First, less drive power is required. Also, fewer components are needed, making for economy of construction. Further, the voltage drop across the switching device of the present invention is much lower than that of prior art solid state switches. In addition, the circuit of the present invention is capable of conducting current in either direction while blocking voltages with respect to the drive reference node of either polarity. The enhancement type MOSFETS employed also have the built-in capacitance needed for rise and fall time control of the switching action.

Briefly described, the switching circuit of the present invention employs a pair of enhancement type MOSFET chips connected in series between a switching control circuit and a circuit the switching of which is to be controlled. The sources of the two MOSFETS are connected together in common as are the gates thereof. The gates are driven in response to a signal from the switching control circuit while the drain of one of the MOSFETS is connected to the power return circuit of the circuit being controlled while the drain of the other MOSFET is connected to the return of the switching control circuit (e.g. common ground). The two MOSFETS are biased at cut-off in the absence of a switching control signal being fed to their gates. A predetermined switching control circuit fed to such gates will activate both MOSFETS, completing the return path for the controlled circuit and thus activitating this circuit.

It is therefore an object of this invention to provide an improved solid state switching circuit requiring fewer components and of lesser cost than prior art circuits of this general type.

It is a further object of this invention to provide an improved solid state switching circuit requiring less power drive and involving less voltage drop than the prior art circuits.

It is still a further object of this invention to provide an improved solid state switching circuit which is capable of conducting current in either direction and which will block voltages of either polarity with respect to the drive reference node.

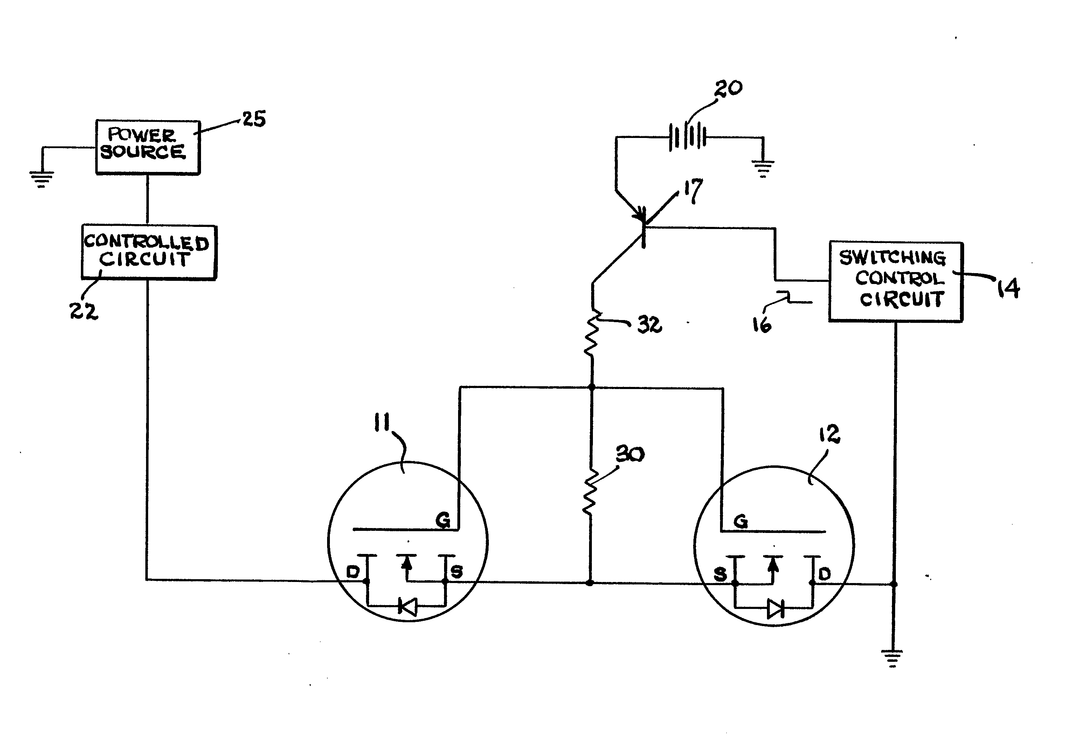

Other objects of this invention will become apparent as the description proceeds in connection with the accompanying drawings of which the sole figure. is a schematic drawing of a preferred embodiment of the invention.

A pair of enhancement type MOSFET chips 11 and 12 are connected together with their gates in common and their sources in common. These MOSFETS may, for example be, type IRF 150, manufactured by International Rectifier Corporation. The drain of MOSFET 12 is connected to the power return for switching control circuit 14 which may be a common "ground" connection. A switching control signal 16, which may typically comprise a negative signal of sufficient amplitude to fire keying transistor 17, is fed from switching control circuit 14 to the base of the transistor to effect the firing thereof. With the firing of transistor 17, a positive voltage from bias source 20 is applied to the gates of the MOSFETS which fires both MOSFETS to the conductive state. The drain of MOSFET 11 is connected to the return circuit for the controlled circuit 22 which may comprise an element in a string array of components which need to be energized in a predetermined manner, in response to switching control circuit 14. This, of course, is only one exemplary use for the switching circuit of the present invention and it could be used to equal advantage in many other different types of switching applications. Controlled circuit 22 receives its power from a suitable power source 25 which uses the same common return (ground) as switching control circuit 14. Thus, when MOSFETS 11 and 12 are fired, the return circuit for controlled circuit 22 is completed causing this circuit to be activated.

Resistor 30 provides cut-off bias between the common sources and gates of the MOSFETS in the absence of a drive signal from transistor 17. Transistor 17 may be, for example, a type 2N5153, manufactured by Texas Instruments. Current limiting resistor 32 is placed in the drive circuit between the collector of transistor 17 and the gates of the MOSFETS to limit the drive current.

As already noted, in the absence of any drive signal, the MOSFETS are held at cut-off by virtue of the biasing voltage developed across resistor 30. When a drive signal, as indicated by signal 16 is present, both MOSFETS 11 and 12 go to their conductive state to provide a very low resistance path (typically of the order of .1 ohm) between the two drain terminals thus effectively completing the return circuit for controlled circuit 22 and causing this circuit to go to the ON state. The built-in capacitances of the MOSFETS provide for slow turn-off and turn-on without the need for external capacitors. Turn-off and turn-on times can be determined by adjusting the values of resistors 30 and 32 as may be desired.

While the invention has been described and illustrated in detail, it is to clearly understood that this is intended by way of illustration and example only and is not to be taken by way of limitation, the spirit and scope of the invention being limited only by the terms of the following claims.

**Claims**

1. A solid state switching circuit for switching a controlled circuit to the "ON" and "OFF" states in response to a control signal from a control circuit comprising:

a pair of enhancement type MOSFETS with their gates connected together in common and their sources connected together in common, the drain of one of said MOSFETS being connected to the power return on the control circuit and the drain of the other of said MOSFETS connected to the return circuit of the controlled cicuit;

means for biasing said MOSFETS at cutoff in the absence of a drive signal therefor; and

means connected to the gates of said MOSFETS for driving said MOSFETS to the conductive state in response to said control signal from said control circuit thereby providing a low resistance path between the drains of the MOSFETS and activating the controlled circuit to the "ON" state.

2. The switching circuit of Claim 1 wherein the means for biasing said MOSFETS comprises a resistor connected between the gates and sources of the MOSFETS.

3. The switching circuit of Claim 1 wherein the means for driving said MOSFETS comprises a transistor, said transistor being driven to its conductive state by said control signal, and a bias source connected to said transistor, said bias source being connected through the transistor to the gates of said MOSFETS when the transistor is conductive.

SWITCHING CONTROL CIRCUIT 14

16 17

20

12 D G S

11 G S D

32 30

POWER SOURCE 25

CONTROLLED CIRCUIT 22

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 500 802 (JANUTKA) <br> * Column 1, line 53 - column 2, line 35; figure 1 * <br><br> ----- | 1-3 | H 03 K 17/687 |

TECHNICAL FIELDS
SEARCHED (Int. Cl.4)

H 03 K

The present search report has been drawn up for all claims

| Place of search | Date of completion of the search | Examiner |
|---|---|---|
| THE HAGUE | 16-09-1986 | CANTARELLI R.J.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82